# DEMANDE DE BREVET EUROPEEN

(11) **EP 0 745 863 A1**
(43) Date de publication de la demande: **04.12.1996**
(21) Numéro de dépôt: 96410058.0
(22) Date de dépôt: 24.05.1996
(51) Int. Cl.: G01R 31/12

(54) **Dispositif de détection de décharges électriques pour appareillage électrique**

(30) Priorité: 29.05.1995 FR 9506618
(71) Demandeur: SCHNEIDER ELECTRIC SA, 92100 Boulogne Billancourt (FR)
(72) Inventeur: Almosnino, Patrick, 38050 Grenoble Cedex 09 (FR); Maulat, Catherine, 38050 Grenoble Cedex 09 (FR)
(74) Mandataire: Jouvray, Marie-Andrée

(57) **Abrégé**

Le dispositif de détection comporte une antenne (4) connectée à un récepteur (6). Le récepteur (6) fournit un signal (SAM) démodulé en amplitude à une unité de traitement (11) et à un circuit (12) d'identification de signaux vidéo. Si le signal démodulé est un signal vidéo le circuit d'identification fournit un signal (SV) d'identification, et le signal démodulé (SAM) n'est pas considéré comme représentatif d'une décharge électrique. L'unité (11) contrôle la fréquence (Fs) de réception du récepteur (6) et mémorise dans une mémoire (13) les fréquences occupées par des émetteurs hertziens.

Application à de l'appareillage électrique haute tension.

## Description

L'invention concerne un dispositif de surveillance et de détection de décharges électriques comportant
- au moins un capteur de rayonnement électromagnétique,
- des moyens de réception ultra haute fréquence connectés au capteur, recevant des signaux du capteur et fournissant sur une première sortie des signaux de modulation des signaux ultra haute fréquence, et
- des moyens de contrôle connectés aux moyens de réception pour contrôler la fréquence de réception des moyens de réception et traiter les signaux de modulation.

Les dispositifs de détection connus sont généralement installés dans des postes blindés haute tension pour contrôler l'isolement électrique. Les défauts d'isolement électrique se manifestent généralement par des décharges électriques entre des conducteurs haute tension et un blindage de l'appareillage au potentiel de la masse ou de la terre. Les dispositifs de détection détectent et localisent les défauts de manière à permettre des interventions sur le poste et éviter des amorçages complets.

Les décharges électriques produisent un rayonnement électromagnétique haute fréquence. Pour capter ce rayonnement, les dispositifs de détection comportent des antennes et des récepteurs haute fréquence. Le spectre des fréquences des décharges se trouve généralement entre 10MHz et environ 1,5 GHz. Il couvre les bandes de fréquences normalisées des très hautes fréquences nommées couramment VHF et la bande des ultras hautes fréquences UHF.

Les signaux reçus par l'antenne et fournis au récepteur sont démodulés de manière à extraire leur amplitude. Des circuits électroniques des dispositifs de détection traitent les valeurs de l'amplitude des signaux et signalent la présence de décharges électriques.

Les gammes de fréquences VHF et UHF sont très utilisées notamment par des émetteurs hertziens de radiodiffusion, de télévision, de radio-amateurs, de téléphones portables, ou de surveillance aérienne. Le rayonnement de ces émetteurs peut être capté directement ou à travers des conducteurs des appareils par les antennes des dispositifs de détection. Des signaux parasites sont alors superposés aux signaux représentatifs de décharges. Les dispositifs connus ne peuvent pas différencier les signaux des émetteurs et les signaux représentatifs de décharges. La présence de ces signaux parasites perturbe alors le fonctionnement des dispositifs de détection qui risquent de donner des informations erronées.

L'invention a pour but un dispositif de détection de décharges électriques non perturbé par des signaux parasites générés par des émetteurs hertziens.

Ce but est atteint par le fait que les moyens de réception comportent des moyens de syntonisation recevant les signaux ultra haute fréquence et des premiers moyens de démodulation fournissant un premier signal de modulation des ultra haute fréquence, lesdits moyens de syntonisation fonctionnant dans des bandes de fréquence réservées aux émissions de télévision, et ledit dispositif de surveillance et de détection comporte des moyens d'identification de signaux de modulation connectés entre les premiers moyens de démodulation et les moyens de contrôle, lesdits moyens d'identification fournissant des signaux d'identification aux moyens de contrôle si les signaux de modulation ont les caractéristiques de signaux télévision.

Dans un mode de réalisation préférentiel, le dispositif comporte des seconds moyens de démodulation connectés entre une seconde sortie des moyens de réception et les moyens de contrôle, la seconde sortie des moyens de réception fournissant des signaux de fréquence intermédiaire et les seconds moyens de démodulation fournissant aux moyens de contrôle des seconds signaux de modulation.

Selon un mode particulier de réalisation, les moyens de contrôle comportent des premiers moyens de balayage en fréquence entre une fréquence inférieure et une fréquence supérieure prédéterminées, le balayage en fréquence étant réalisé par pas de valeur égale à une largeur de bande d'un canal de télévision.

Selon un développement de l'invention, les moyens de contrôle comportent des moyens de mémorisation de bandes de fréquence occupées par les émissions de télévision.

Les moyens de contrôle comportent des seconds moyens de balayage en fréquence entre une fréquence inférieure et une fréquence supérieure prédéterminées, le balayage étant réalisé en dehors des bandes fréquence mémorisées dans les moyens de mémorisation.

De préférence, les moyens de contrôle comportent des moyens de comparaison de valeurs représentatives des premiers signaux de modulation avec un seuil prédéterminé.

Selon un développement des modes de réalisation de l'invention, les seconds moyens de démodulation comportent un oscillateur, un mélangeur connecté à l'oscillateur et à une entrée recevant les signaux de fréquence intermédiaire, des moyens de filtrage connectés au mélangeur et des moyens de démodulation d'amplitude bande étroite connectés aux moyens de filtrage et à une sortie fournissant les seconds signaux de modulation.

L'oscillateur fournit une fréquence variable, la fréquence variant entre une première et une seconde valeur pendant que les moyens de balayage sont dans un pas de fréquence correspondant à une bande de la largeur d'un canal de télévision en dehors des bandes fréquence mémorisée.

L'oscillateur peut avoir une fréquence variable contrôlée par les moyens de contrôle.

Un dispositif particulier, comporte un circuit de numérisation connecté à la première sortie des moyens de réception et à la sortie des seconds moyens de démodulation, et un bus de communication sur lequel sont connectés les moyens de contrôle, les moyens d'identification, les moyens de réception et ledit circuit de numérisation.

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :

La figure 1 représente un premier mode de réalisation d'un dispositif selon l'invention.

La figure 2 illustre des bandes de fréquences utilisées par un dispositif de détection de décharges selon la figure 1.

La figure 3 montre un organigramme de recherche de bandes de fréquence occupées par des émetteurs hertziens intégré dans un dispositif selon la figure 1.

La figure 4 montre un organigramme de détection de décharges intégré dans un dispositif selon la figure 1.

La figure 5 représente un démodulateur bande étroite utilisé dans un dispositif selon la figure 1.

La figure 6 montre un second mode de réalisation d'un dispositif selon l'invention.

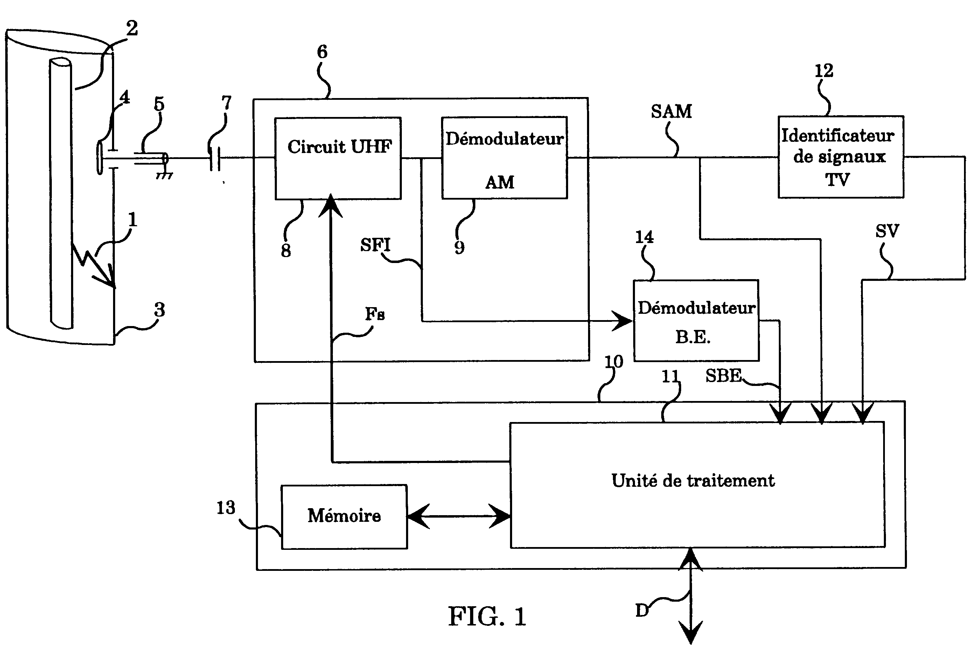

Le dispositif de la figure 1 contrôle l'apparition de décharges électriques 1 entre un conducteur 2 soumis à une haute tension et une cuve 3 de protection et de blindage reliée à la terre ou à la masse de l'installation. Une antenne 4 capte le rayonnement électromagnétique émis par la décharge électrique 1. Un câble blindé 5, de type coaxial, relie l'antenne à une entrée d'un récepteur 6 à travers un condensateur de découplage 7.

Les émetteurs hertziens dans la bande VHF sont généralement nombreux et occupent la totalité de la bande. En outre, le type d'émission est très varié et il n'est pas facile de les identifier. Les dispositifs de détection selon un mode de réalisation de l'invention fonctionnent dans des bandes réservées aux émissions de télévision. Des signaux vidéo véhiculés par les émissions de télévision sont identifiables et normalisés. Il est alors possible de différencier ces signaux vidéo des autres signaux.

La bande de fréquence utilisée par le dispositif de la figure 1 se situe dans les ultra hautes fréquences UHF réservées aux émissions de télévision. Le récepteur 6 comporte un circuit 8 de syntonisation UHF, appelé communément tuner ou tête UHF, et un démodulateur 9 connecté à une sortie du circuit 8.

Le circuit 8 reçoit des signaux UHF venant de l'antenne et fournit des signaux SFI de fréquence intermédiaire sur sa sortie. Une fréquence Fs d'accord est fournie au circuit 8 pour fixer la fréquence de base de réception. La bande passante du circuit 8 est sensiblement égale à une largeur de bande Bc d'un canal de télévision, environ 5 MHz. Les signaux SFI de fréquence intermédiaire ont une fréquence quasi constante, indépendante de la fréquence Fs d'accord, et une bande passante sensiblement égale à une largeur de bande Bc.

Le signal SFI de fréquence intermédiaire est appliqué au démodulateur 9 qui fournit un signal SAM de modulation d'amplitude du signal SFI et du signal d'antenne UHF. La bande passante du signal SAM est aussi sensiblement égale à une largeur de bande Bc.

Le signal de modulation SAM est fourni à un contrôleur 10 qui comporte une unité de traitement 11. L'unité de traitement 11 compare le signal SAM à un seuil prédéterminé SD et fournit un signal D de défaut à une centrale de surveillance si l'amplitude du signal SAM est supérieure au seuil SD. La comparaison au seuil peut également être faite avec une valeur prétraitée représentative du signal SAM , par exemple une intégration, une moyenne ou une valeur efficace du signal SAM.

L'unité de traitement 11 du contrôleur 10 est connecté au circuit 8 et lui fournit des fréquences Fs de manière à balayer en fréquence, entre une fréquence minimale Finf et une fréquence maximale Fsup, le signal reçu par l'antenne. Le balayage en fréquence est fait par pas de largeur égale à une largeur de bande Bc. Ainsi, tout le spectre de fréquence entre les fréquences Finf et Fsup est balayé et contrôlé par contrôleur 10.

Dans ce mode de réalisation selon l'invention, le dispositif de détection comporte un circuit 12 d'identification de signaux de télévision. Le circuit 12 à une entrée connectée à la sortie du démodulateur 9, et une sortie connectée à l'unit de traitement 11. Ce circuit 12 d'identification permet de reconnaître les signaux SAM présentant les caractéristiques de signaux vidéo. Lesdits signaux vidéo comportent des signaux de synchronisation lignes et trames normalisés et facilement identifiables.

Lorsque le signal SAM est un signal vidéo de circuit 12 fournit à l'unité de traitement une information SV. En présence de cette information SV, l'unité de traitement ne prend pas en compte le dépassement de seuil, SAM supérieur à SD. Le signal reçu par l'antenne dans la fréquence FS du circuit 8 est, dans ce cas, un signal d'un émetteur de télévision.

Les valeurs des fréquences Fs pour lesquelles des émissions de télévision sont détectées sont avantageusement sauvegardées. le contrôleur 10 comporte une mémoire 13 connectée à l'unité de traitement pour stocker les valeurs des fréquences d'émission de télévision.

Les signaux représentatifs de décharges électriques peuvent avoir des bandes étroites. Il est alors nécessaire de les surveiller avec une bande réduite pour avoir un signal démodulé ayant un bon rapport signal sur bruit.

Le dispositif de la figure 1 comporte un démodulateur 14 bande étroite connecté à la sortie du circuit 8 pour recevoir le signal SFI, et à une entrée de l'unité de traitement pour fournir un signal SBE démodulé en bande étroite.

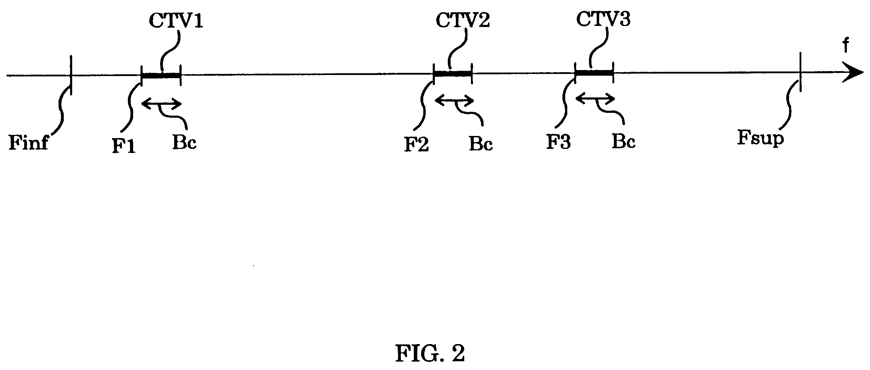

La figure 2 illustre la bande de fréquence utilisée par le dispositif pour détecter les décharges électriques. la bande de fréquence se situe entre une fréquence inférieure Finf et une fréquence supérieure Fsup dans les fréquences réservées aux émissions de télévision, de préférence dans les UHF. Dans la bande de fréquence de la figure 2, trois canaux de télévision CTV1, CTV2 et CTV3 sont utilisés par des émetteurs hertziens. Chaque canal a une fréquence de base, respectivement F1, F2 et F3, et une bande passante Bc. La détection des décharges va se faire dans des fréquences entre Finf et Fsup et entre les canaux CTV1, CTV2 et CTV3. Dans le cas de la figure 2 les fréquences utilisables se trouvent entre Finf et F1, F1 + Bc et F2, F2 + Bc et F3, et entre F3 + Bc et F sup.

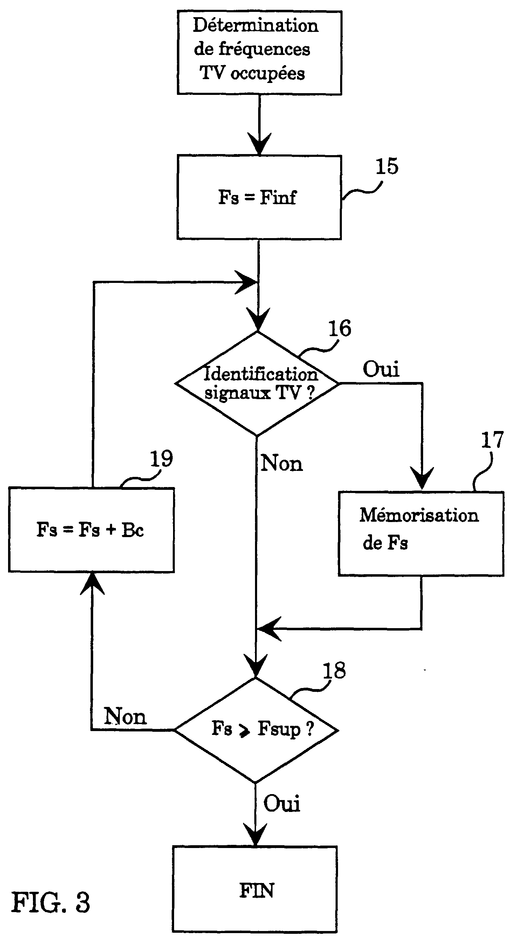

Un cycle d'initialisation permet de rechercher et de mémoriser les fréquences occupées par les émetteurs. Un exemple de cycle d'initialisation est représenté par un organigramme sur la figure 3.

Au début de la recherche des fréquences occupées, l'organigramme comporte une étape 15 d'initialisation de la fréquence Fs de syntonisation, Fs est alors égale à la fréquence inférieure F inf. A une étape 16 si la fréquence Fs est occupée par un émetteur de télévision l'unité 11 reçoit des signaux SV d'identification. la fréquence Fs est alors mémorisée (étape 17). Si la fréquence Fs est libre, elle n'est pas mémorisée. Une étape 18 permet de contrôler si la fréquence supérieure Fsup est atteinte par Fs. Tant que Fs n'est pas supérieure ou égale à Fsup, la fréquence Fs est incrémentée (étape 19) d'une largeur de bande Bc d'un canal de télévision, et le cycle recommence à l'étape 16.

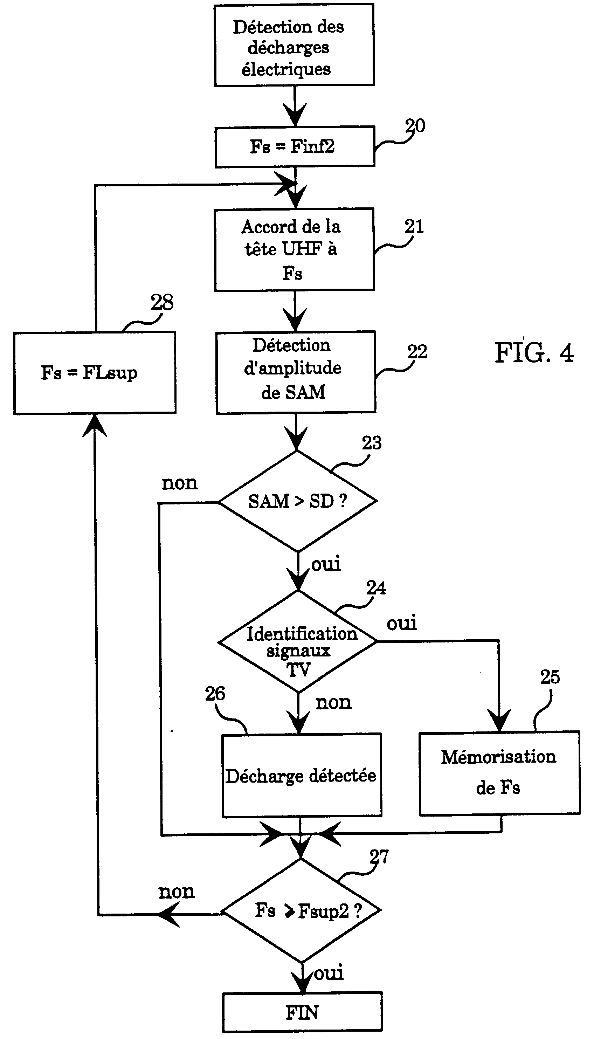

La détection des décharges électriques peut se faire aussi selon un cycle de balayage entre les fréquences Finf et Fsup. Un exemple d'organigramme de la détection de décharge est représenté sur la figure 4.

Lors d'une étape 20 d'initialisation la fréquence Fs est égale à une fréquence inférieure Finf2. Cette fréquence correspond à Finf si elle est libre ou à la première fréquence inférieure libre. La fréquence Fs est fournie par l'unité 11 au circuit 8 (étape 21). Le démodulateur 9 fournit le signal SAM (étape 22). Puis dans une étape 23, l'unité 11 compare une valeur représentative du signal SAM au seuil SD. Si le seuil SD est dépassé, à une étape 24 l'unité 11 contrôle que le signal n'est pas représentatif de l'émission d'un nouvel émetteur. Si SAM est un signal vidéo la fréquence courante est mémorisée (étape 25) et le dépassement de seuil n'est pas considéré comme représentatif d'une décharge. Si SAM n'est pas un signal vidéo l'unité signale (étape 26) la présence d'un défaut d'isolement.

Tant que Fs n'est pas supérieure à une fréquence Fsup2, le cycle recommence à l'étape 21. A chaque cycle, lors d'une étape 28 d'incrémentation, Fs est remplacée par une fréquence libre FLsup immédiatement supérieure à la dernière valeur de Fs de manière à sauter les fréquences déjà occupées par des émetteurs hertziens. la fréquence Fsup2 est la dernière fréquence supérieure libre, inférieure à Fsup.

Le pas d'incrémentation de Fs et FLsup est de préférence égal à la largeur de bande Bc d'un canal de télévision. Mais le pas peut avoir d'autres valeurs, notamment des valeurs inférieures à Bc pour une scrutation fine du spectre de fréquence.

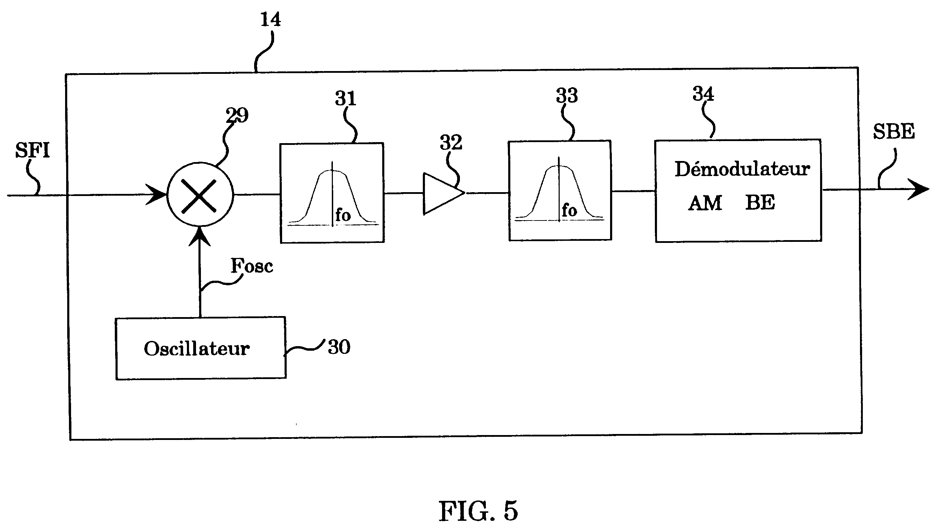

Un schéma d'un démodulateur 14 bande étroite est représenté sur la figure 5. Il permet une détection des décharges avec un rapport signal sur bruit amélioré. La bande passante, qui est d'environ 5MHz pour le signal SAM, est de quelques KHz pour le signal SBE fourni par le démodulateur 14.

Le démodulateur 14 comporte un mélangeur 29 recevant le signal d'entrée SFI et un oscillateur 30 connecté au mélangeur 29 et fournissant un signal de fréquence Fosc. La sortie du mélangeur 29 est connectée à un premier filtre passe-bande 31 connecté en chaîne avec un amplificateur 32 et un second filtre 33. la sortie du filtre 33 passe-bande est connectée à un démodulateur d'amplitude 34 qui fournit sur la sortie du démodulateur le signal SBE.

La bande passante du signal SBE est fixée par les filtres 31 et 33 en bande étroite.

Dans le cas où le pas d'incrémentation du circuit 8 n'est pas suffisament petit, l'oscillateur peut fournir une fréquence Fosc variable pour scruter l'ensemble du spectre su signal SFI. La fréquence Fosc variant entre une valeur minimale et une valeur maximale, l'écart entre lesdites valeurs est sensiblement égale à une largeur de bande Bc ou à une largeur de pas différente. la valeur de la fréquence Fosc peut être fournie par le contrôleur 10.

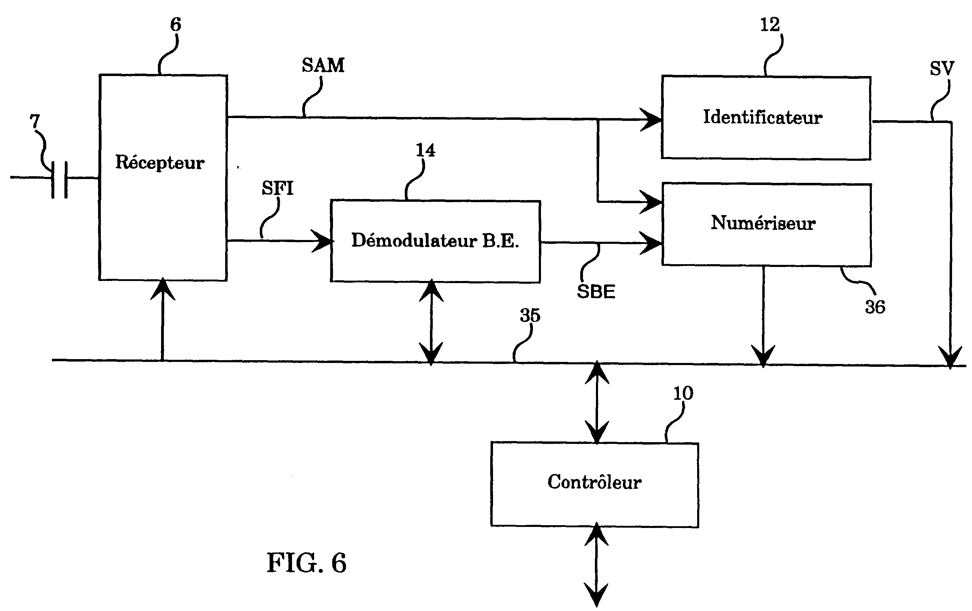

La figure 6 présente un autre mode de réalisation d'un dispositif selon l'invention. Les liaisons entre le contrôleur 10 et les autres éléments du dispositif sont faites à travers un bus de communication 35. Les signaux analogiques SAM et SBE dont numérisés par un circuit de numérisation 36 qui fait l'interface avec le bus 35.

Dans d'autres modes de réalisation le contrôleur 10 peut contrôler plusieurs récepteurs 6 et recevoir des signaux de plusieurs démodulateurs 9 et 14 et circuits 12 d'identification.

## Revendications

1. Dispositif de surveillance et de détection de décharges électriques comportant
- au moins un capteur (4) de rayonnement électromagnétique,
- des moyens (6) de réception ultra haute fréquence connectés au capteur, recevant des signaux du capteur et fournissant sur une première sortie des signaux (SAM) de modulation des signaux ultra haute fréquence, et
- des moyens (10, 11) de contrôle connectés aux moyens (6) de réception pour contrôler la fréquence (Fs) de réception des moyens de réception et traiter les signaux (SAM) de modulation.
dispositif caractérisé en ce que :
- les moyens de réception (6) comportent des moyens (8) de syntonisation recevant les signaux ultra haute fréquence et des premiers moyens (9) de démodulation fournissant un premier signal (SAM) de modulation des ultra haute fréquence, lesdits moyens de syntonisation fonctionnant dans des bandes de fréquence réservées aux émissions de télévision, et
- ledit dispositif de surveillance et de détection comporte des moyens (12) d'identification de signaux (SAM) de modulation connectés entre les premiers moyens (9) de démodulation et les moyens (10, 11) de contrôle, lesdits moyens d'identification (12) fournissant des signaux (SV) d'identification aux moyens de contrôle si les signaux de modulation ont les caractéristiques de signaux télévision.

2. Dispositif selon la revendication 1 caractérisé en ce qu'il comporte des seconds moyens (14) de démodulation connectés entre une seconde sortie des moyens de réception et les moyens de contrôle, la seconde sortie des moyens de réception fournissant des signaux (SFI) de fréquence intermédiaire et les seconds moyens (14) de démodulation fournissant aux moyens de contrôle des seconds signaux (SBE) de modulation.

3. Dispositif selon l'une des revendications 1 et 2 caractérisé en ce que les moyens de contrôle comportent des premiers moyens de balayage en fréquence entre une fréquence (Finf) inférieure et une fréquence (Fsup) supérieure prédéterminées, le balayage en fréquence étant réalisé par pas de valeur égale à une largeur de bande (Bc) d'un canal de télévision.

4. Dispositif selon l'une quelconque des revendications 1 à 3 caractérisé en ce que les moyens de contrôle comportent des moyens (13) de mémorisation de bandes de fréquence occupées par les émissions de télévision.

5. Dispositif selon la revendication 4 caractérisé en ce que les moyens de contrôle comportent des seconds moyens de balayage en fréquence entre une fréquence (Finf2) inférieure et une fréquence (Fsup2) supérieure prédéterminées, le balayage étant réalisé en dehors des bandes fréquence mémorisées dans les moyens (13) de mémorisation.

6. Dispositif selon l'une quelconque des revendications 1 à 5 caractérisé en ce que les moyens de contrôle comportent des moyens (23) de comparaison de valeurs représentatives des premiers signaux (SAM) de modulation avec un seuil (SD) prédéterminé.

7. Dispositif selon l'une quelconque des revendications 2 à 6 caractérisé en ce que les seconds moyens de démodulation comportent un oscillateur (30), un mélangeur (29) connecté à l'oscillateur et à une entrée recevant les signaux (SFI) de fréquence intermédiaire, des moyens (31, 32, 33) de filtrage connectés au mélangeur et des moyens (34) de démodulation d'amplitude bande étroite connectés aux moyens de filtrage et à une sortie fournissant les seconds signaux (SBE) de modulation.

8. Dispositif selon la revendication 7 caractérisé en ce que l'oscillateur fournit une fréquence (Fosc) variable, la fréquence variant entre une première et une seconde valeur pendant que les moyens de balayage sont dans un pas de fréquence correspondant à une bande de la largeur d'un canal de télévision en dehors des bandes fréquence mémorisée.

9. Dispositif selon l'une des revendications 7 et 8 caractérisé en ce que l'oscillateur a une fréquence (Fosc) variable contrôlée par les moyens (10, 11) de contrôle.

10. Dispositif selon l'une quelconque des revendications 2 à 9 caractérisé en ce qu'il comporte un circuit (36) de numérisation connecté à la première sortie des moyens de réception et à la sortie des seconds moyens de démodulation, et un bus (35) de communication sur lequel sont connectés les moyens (10, 11) de contrôle, les moyens (12) d'identification, les moyens de réception (6) et ledit circuit (12) de numérisation.
